Europäisches Patentamt

European Patent Office

Office européen des brevets

(19)

(11) Veröffentlichungsnummer: **0 284 845 B1**

(12)

# EUROPÄISCHE PATENTSCHRIFT

(45) Veröffentlichungstag der Patentschrift:
05.06.91 Patentblatt 91/23

(51) Int. Cl.$^5$: **H05K 1/00**

(21) Anmeldenummer: **88103637.0**

(22) Anmeldetag: **08.03.88**

(54) **Rückwandleiterplatte.**

(30) Priorität: **20.03.87 DE 3709118**

(43) Veröffentlichungstag der Anmeldung:
**05.10.88 Patentblatt 88/40**

(45) Bekanntmachung des Hinweises auf die
Patenterteilung:
**05.06.91 Patentblatt 91/23**

(84) Benannte Vertragsstaaten:
**CH DE FR GB LI**

(56) Entgegenhaltungen:
**EP-A- 0 004 899**
**EP-A- 0 195 955**
**DE-A- 2 233 578**

(56) Entgegenhaltungen:
**DE-U- 8 410 261**
**FR-A- 2 525 065**
**GB-A- 1 523 136**
**JEE, JOURNAL OF ELECTRONIC ENGINEE-
RING, Band 17, Nr. 157, Januar 1980, Seiten
30,31; Tokyo, JP; Y. GOTO: "DIP switches
achieve high density switching"**

(73) Patentinhaber: **Siemens Aktiengesellschaft
Wittelsbacherplatz 2
W-8000 München 2 (DE)**

(72) Erfinder: **Brune, Johannes, Dipl.-Ing.
Am Deckesweiher 4
W-8520 Erlangen (DE)**
Erfinder: **Latussek, Hans-Peter, Dipl.-Ing.
Heideweg 77
W-8501 Feucht (DE)**

## Beschreibung

Die Erfindung bezieht sich auf eine Rückwandleiterplatte mit mehreren parallel nebeneinander auf der den Baugruppen zugewandten Seite angeordneten Federleisten und mit wenigstens einem Bus, der aus mehreren Busleitungen besteht.

Derartige Rückwandleiterplatte sind im Handel erhältlich und beispielsweise als VME-Bus-Leiterplatte bekannt. Dabei ist der VME-Bus ein standardisierter Bus, der für den grundlegenden schnellen Datenverkehr zwischen den wichtigsten Komponenten eines Bussystems zuständig ist. Dabei bildet die Busstruktur die Verbindungsschienen zwischen den Bausteinen und -gruppen eines Mikro- oder Minicomputersystems. Je nach den verwendeten Systemkomponenten und der geforderten Leistungsfähigkeit variieren auch die Busstrukturen. Da der gesamte Datenaustausch über derartige Bussysteme erfolgt, beeinflußt deren Struktur die Leistungsfähigkeit des Gesamtsystems. Der Datenaustausch erfolgt beispielsweise im 8-, 16- oder 32-Bit-Format, d.h., es sind beispielsweise 8, 16 oder 32 Busleitungssysteme vorgesehen, die die einzelnen Baugruppen eines Bussystems untereinander verbinden. Bei derartigen baugruppenübergreifenden Bussystemen kann ein Fehler, beispielsweise ein Kurzschluß eines Ausgangstreibers mit der Versorgungsspannung eines Busteilnehmers, das gesamte Bussystem blockieren. Eine Lokalisierung des defekten Busteilnehmers ist bei vielen Fehlerarten mit Hilfe einer Diagnoseroutine möglich. Jedoch können einige Fehlerarten nur dadurch ermittelt werden, daß nacheinander alle Busteilnehmer vom Bus getrennt werden bis der defekte Teilnehmer gefunden und damit die Störung behoben ist. Beim Herausziehen der einzelnen Busteilnehmer aus ihren Steckplätzen in einem Baugruppenträger wird die gesamte Funktion des betroffenen Teilnehmers außer Betrieb gesetzt. Dies bringt erhebliche Einschränkungen der Verfügbarkeit des Systems mit sich.

Der Erfindung liegt nun die Aufgabe zugrunde, eine Rückwandleiterplatte der eingangs genannten Art so weiterzubilden, daß mindestens eine Baugruppe von einem baugruppenübergreifenden Bus abgetrennt werden kann, ohne dabei die Baugruppe selbst aus ihrem Steckplatz eines Baugruppenträgers herausziehen zu müssen.

Diese Aufgabe wird erfindungsgemäß dadurch gelöst, daß jeweils die als Buskontaktstifte vorgesehenen Kontaktstifte der äußeren Kontaktstiftreihen der Federleisten kürzer sind als die Kontaktstifte der mittleren Kontaktstiftreihen, daß jeweils in Flucht zu diesen Buskontaktstiften einer jeden Federleiste die Rückwandleiterplatte mit zusätzlichen Kontaktstiften versehen ist, wobei diese einem Bus zugehörigen zusätzlichen Kontaktstifte mittels der Busleitungen elektrisch leitend miteinander verbunden sind, und daß die Buskontaktstiften einer jeden Federleiste jeweils mit den korrespondierenden zusätzlichen Kontaktstiften über ein mittels eines Handhabungsmittels bewegbares Kontaktmittel elektrisch leitend verbindbar sind.

Dadurch, daß jeweils die als Buskontaktstifte vorgesehenen Kontaktstifte der Federleisten jeweils mittels eines beweglichen Kontaktmittels mit jeweils einem zusätzlichen Kontaktstift elektrisch leitend verbindbar sind, kann man jede beliebige an einen baugruppenübergreifenden Bus angeschlossene Baugruppe von diesem Bus elektrisch trennen, ohne dabei diese Baugruppe aus ihrem Steckplatz eines Baugruppenträgers herausziehen zu müssen. Diese Kontaktmittel können beispielsweise mittels eines Handhabungsmittels, das auf der den Baugruppen abgewandten Seite der Rückwandleiterplatte angeordnet ist, von der elektrisch leitende Position in die elektrisch trennende Position bewegt werden. Besonders vorteilhaft ist es, daß die Kontaktmittel und die Handhabungsmittel im Schatten einer jeden Federleiste angeordnet sind, wobei zusätzlicher Platz nötig wird. Außerdem ist jeweils das Handhabungsmittel mit dem beweglichen Kontaktmittel verbindbar und auf einander gegenüberliegenden Seiten der Rückwandleiterplatte angeordnet. Da das Handhabungsmittel nachträglich mit dem Kontaktmittel verbindbar ist, vereinfacht sich die Montage wesentlich, weil die Rückwandleiterplatte über ein Schwallbad geführt werden kann.

In einer vorteilhaften Ausführungsform des beweglichen Kontaktmittels ist als bewegliches Kontaktmittel ein zylinderförmiger Kontakt vorgesehen, der jeweils im Stirnbereich mit einer ringförmigen Kontaktnase im Innern versehen ist. Mit Hilfe dieser ringförmigen Kontaktnasen ist es möglich, entstandene Oxidschichten auf den Buskontaktstiften und den zusätzlichen Kontaktstiften zu entfernen.

In einer weiteren Ausführungsform der Rückwandleiterplatte ist als bewegliches Kontaktmittel federnde Kontaktstifte vorgesehen, die jeweils mit einem Buskontaktstift verbunden sind und mittels ihrer Federkraft am zusätzlichen Kontaktstift anliegen. Auch bei dieser Gestaltung des beweglichen Kontaktmittels werden entstandene Oxidschichten auf den zusätzlichen Kontaktstiften mittels einer hohen Flächenpressungen der federnden Kontaktstifte entfernt.

Die Kontaktierung zwischen den Buskontaktstiften und die zusätzlichen Kontaktstiften wird in Verbindung mit den federnden Kontaktstiften und den Handhabungsmitteln gesteuert. Dabei ist jeweils das auf der den Baugruppen zugewandten Seite der Rückwandleiterplatte angeordnete Trennteil des Handhabungsmittels, derart gestaltet, daß die Trennbewegung, d.h. eine zu den Kontaktstiften der Federleisten axile Verschiebung der Handhabe, sich in eine Abhebbewegung der federnden Kontaktstifte ändert.

In einer weiteren vorteilhaften Ausführungsform der Rückwandleiterplatte ist jede Federleiste mit einem Abstandshalter versehen, wobei der Abstandshalter sich jeweils über die Gesamtlänge der Federleiste erstreckt. Dadurch sind jeweils die Federleisten justiert und ihre Kontaktstifte gekapselt. Außerdem werden die Federleisten jeweils seitlich durch den Abstandshalter gestützt.

Zur weiteren Erläuterung der Erfindung wird auf die Zeichnung Bezug genommen, in der Ausführungsbeispiele nach der Erfindung schematisch veranschaulicht sind.

FIG 1 zeigt eine erfindungsgemäße Ausführungsform, die

FIG 2 veranschaulicht eine Draufsicht auf der den Baugruppen abgewandten Seite einer Rückwandleiterplatte nach der Erfindung und die

FIG 3 zeigt eine weitere Ausführungsform nach der Erfindung.

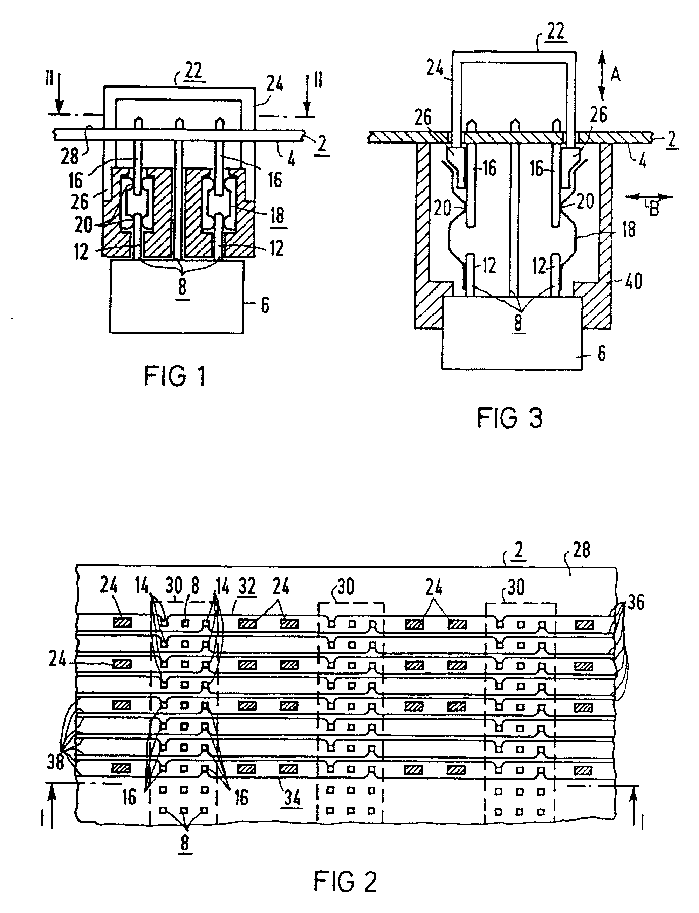

Die FIG 1 zeigt eine Rückwandleiterplatte 2 mit mehreren parallel nebeneinander auf der den Baugruppen zugewandten Seite 4 angeordneten Federleisten 6, von den aus Übersichtlichkeitsgründen nur eine Federleiste 6 dargestellt ist. Die Kontaktstifte 8 dieser Federleiste 6, die als Buskontaktstifte 10 bzw. 12 vorgesehen sind und jeweils Kontaktstifte 8 einer äußeren Konstaktstiftreihe sind, sind kürzer als die Kontaktstifte 8 der mittleren Kontaktstiftreihe. Die Buskontaktstifte 10 sind von den Buskontaktstiften 12 verdeckt. Jedem Buskontaktstift 10 bzw. 12 ist jeweils ein zusätzlicher Kontaktstift 14 bzw. 16 zugeordnet, der jeweils in Flucht zu den Buskontaktstiften 10 bzw. 12 in der Rückwandleiterplatte 2 auf der den Baugruppen zugewandten Seite 4 angeordnet ist. Als elektrisch leitende Verbindung zwischen einem Buskontaktstift 10 bzw. 12 und einem zusätzlichen Kontaktstift 14 bzw. 16 ist ein bewegliches Kontaktmittel 18 vorgesehen. Als Kontaktmittel 18 ist ein zylinderförmiger Kontakt vorgesehen, in dem jeweils im Stirnbereich im Innern eine ringförmige Kontaktnase 20 angeordnet ist. Jeweils zwei Kontaktmittel 18, die einen Kontaktstift 8 der mittleren Kontaktstiftreihe einer jeden Federleiste 6 umschließen, bilden ein Bauteil. Besonders vorteilhaft ist es, wenn die Kontaktmittel 18 eines Busses eine Baueinheit bilden. Dabei dienen die Kontaktstifte 8 jeweils der mittleren Kontaktstiftreihe einer jeden Federleiste 6 als Führung für das Kontaktmittel 18. Ferner ist das Kontaktmittel 18 mit einem Handhabungsmittel 22 versehen, wobei die Handhabe 24 und das Trennteil 26 auf einander gegenüberliegenden Seiten 4 und 28 der Rückwandleiterplatte 2 angeordnet und trennbar ausgeführt sind. Da die Handhabe 24 des Handhabungsmittels 22 vom Trennteil 26 lösbar ist, kann man bei der Fertigung der Rückwandleiterplatte 2 auf die Handhaben 24 verzichten, damit die Rückwandleiterplatte 2 über ein Schwallbad geführt werden kann. Außerdem hat diese Ausführungsform den Vorteil, daß nur im Störfall wenigstens eine Handhabe 24 benötigt wird, um eine defekte Baugruppe vom baugruppenübergreifenden Bus zu trennen. Das Trennteil 26 greift im Kontaktmittel ein. Durch die Bewegung des Handhabungsmittels 22 die Kontaktierung jeweils zwischen den Buskontaktstiften 10 bzw. 14 und den zusätzlichen Kontaktstiften 14 bzw. 16 steuerbar. Durch die vorhandenen Kontaktnasen 20 des Kontaktmittels 18 kann eine an den Kontaktstiften 10, 14 bzw. 12, 16 entstandene Oxidschicht entfernt werden.

Die FIG 2 zeigt eine Draufsicht auf der den Baugruppen abgewandte Seite 28 der Rückwandleiterplatte 2 nach einem Schnitt II-II nach FIG 1. Die Federleisten 6, die auf der den Baugruppen zugewandten Seite 4 der Rückwandleiterplatte 2 angeordnet sind, sind auf der den Baugruppen abgewandten Seite 28 der Rückwandleiterplatte 2 jeweils mit einer unterbrochenen Linie 30 dargestellt. Als Federleisten 6 sind jeweils beispielsweise 96-polige Federleisten vorgesehen, wobei die Kontaktstifte 8 jeweils in drei Reihen angeordnet sind. Außerdem sind zwei Busse 32 bzw. 34 vorgesehen, die jeweils acht Busleitungen 36 bzw. 38 haben. Dabei ist der Bus 34 redundant zum Bus 32 aufgebaut. Bei einem baugruppenübergreifenden Bussystem 32 bzw. 34 mit acht parallel nebeneinander angeordneten Busleitungen 36 bzw. 38 hat jede Federleiste 6 acht Buskontaktstifte 10 bzw. 12, von denen jeweils vier Buskontaktstifte 10 bzw. 12 in den äußeren Kontaktstiftreihen einer jeden Federleiste 6 angeordnet sind. Auf dieser den Baugruppen abgewandten Seite 28 der Rückwandleiterplatte 2 sind nur die zusätzlichen Kontaktstifte 14 bzw. 16, die in Flucht zu den Buskontaktstiften 10 bzw. 12 angeordnet sind, zu sehen. Dabei sind die zusätzlichen Kontaktstifte 14 der Federleiste 6 jeweils mit einer Busleitung 36 des Busses 32 baugruppenübergreifend miteinander elektrisch leitend verbunden. Die zusätzlichen Kontaktstifte 16 der Federleisten 6 sind jeweils mit einer Busleitung 38 des Busses 34 baugruppenübergreifend miteinander elektrisch leitend verbunden. Da die Busse 32 bzw. 34 ein Format von acht Busleitungen 36 bzw. 38 haben, muß die Tiefe des Handhabungsmittels 22 der Breite des Busses 32 bzw. 34 entsprechen.

Im betriebsmäßigen Zustand der Rückwandleiterplatte 2 sind alle Busteilnehmer-Baugruppen an den beiden Bussen 32 und 34 angeschlossen, wobei der Datentransfer zwischen den einzelnen Busteilnehmer-Baugruppen auf dem Bus 32 stattfindet. Wenn nun ein Fehler auftritt, der diesen Bus 32 stört, kann auf den redundanten Bus 34 umgeschaltet werden. Dadurch bleibt trotz eines auftretenden Fehlers das System in Betrieb. Die Fehlersuche erfolgt nun auf dem gestörten Bus 32, in dem man nacheinander die Baugruppen mittels der Handhabungsmittel 22 und der Kontaktmittel 18 vom Bus 32 trennt. In Verbindung mit einer geeigneten Testroutine wird festgestellt, bei welcher Baugruppe die Blockierung des Busses 32 behoben ist. Die so lokalisierte defekte Busteilnehmer-Baugruppe kann nun ausgetauscht werden. Durch diese indirekte Ankopplung der Busteilnehmer-Baugruppen an die baugruppenübergreifenden Busse 32 bzw. 34 können jederzeit einzelne Baugruppen von den Busses 32 bzw. 34 getrennt werden, ohne dabei die Baugruppe aus ihrem Steckplatz eines Baugruppenträgers herausziehen zu müssen. Dadurch bleiben zusätzliche Funktionen dieser vom Bus getrennten Baugruppe in Betrieb, wodurch die Verfügbarkeit des Systems vergrößert wird.

Die FIG 3 zeigt eine weitere Ausführungsform der Rückwandleiterplatte 2, wobei nur ein Teil mit einer Federleiste 6 dargestellt ist. Bei dieser Ausführungsform sind als Kontaktmittel 18 federnde Kontaktstifte vorgesehen, die einerseits mit dem Buskontaktstift 10 bzw. 12 elektrisch leitend verbunden sind und andererseits mittels ihrer Federkraft gegen die entsprechenden zusätzlichen Kontaktstifte 14 bzw. 16 gedrückt werden. Außerdem ist ein Abstandshalter 40 vorgesehen, der zwischen der den Baugruppen zugewandten Seite 4 der Rückwandleiterplatte 2 und der Federleiste 6 angeordnet ist. Dadurch wird die Federleiste 6 seitlich auf einen vorbestimmten Abstand gehalten und stützt zusätzlich die mittlere Kontaktstiftreihe der Federleiste 6 ab. Das Trennteil 26 der Handhabungsmittel 22, auf dem sich der federnde Kontaktstift abstützt, ist derartig gestaltet, daß eine Trennbewegung, gekennzeichnet durch einen Doppelpfeil A, sich in eine Abhebbewegung des federnden Kontaktstiftes, gekennzeichnet durch einen Doppelpfeil B, ändert. Bei diesem Bewegungsablauf werden die federnden Kontaktstifte mit ihren Kontaktnasen 20 kratzend an den zusätzlichen Kontaktstiften 14 bzw. 16 entlanggeführt. Dadurch werden entstandene Oxidschichten entfernt. Außerdem ist bei jedem Handhabungsmittel 22 das Trennteil 26 und die Handhabe 24 trennbar ausgeführt, wodurch die Fertigung der Rückwandleiterplatte 2 sich wesentlich vereinfacht, da die Handhabe 24 bei Bedarf nachträglich mit dem Trennteil 26 verbunden werden kann.

## Ansprüche

1. Rückwandleiterplatte (2) mit mehreren parallel nebeneinander auf der den Baugruppen zugewandten Seite (4) angeordneten Federleisten (6) und mit wenigstens einem Bus (32, 34), der aus mehreren Busleitungen (36, 38) besteht, **dadurch gekennzeichnet,** daß jeweils die als Buskontaktstifte (10, 12) vorgesehenen Kontaktstifte (8) der äußeren Kontaktstiftreihen der Federleisten (6) kürzer sind als die Kontaktstifte (8) der mittleren Kontaktstiftreihen, daß jeweils in Flucht zu diesen Buskontaktstiften (10, 12) einer jeden Federleiste (6) die Rückwandleiterplatte (2) mit zusätzlichen Kontaktstiften (14, 16) versehen ist, wobei diese einem Bus (32, 34) zugehörigen zusätzlichen Kontaktstifte (14, 16) mittels der Busleitungen (36, 38) elektrisch leitend miteinander verbunden sind, und daß die Buskontaktstifte (10, 12) einer jeden Federleiste (6) jeweils mit den korrespondierenden zusätzlichen Kontaktstiften (14, 16) über ein mittels eines Handhabungsmittels (22) bewegbares Kontaktmittel (18) elektrisch leitend verbindbar sind.

2. Rückwandleiterplatte (2) nach Anspruch 1, **dadurch gekennzeichnet,** daß als bewegbares Kontaktmittel (18) ein zylinderförmiger Kontakt vorgesehen ist, der jeweils im Stirnbereich im Innern mit einer ringförmigen Kontaktnase (20) versehen ist.

3. Rückwandleiterplatte (2) nach Anspruch 2, **dadurch gekennzeichnet,** daß als bewegbares Kontaktmittel (18) federnde Kontaktstifte vorgesehen sind, die jeweils mit einem Buskontaktstift (10, 12) verbunden sind und mittels ihrer Federkraft am zusätzlichen Kontaktstift (14, 16) anliegen.

4. Rückwandleiterplatte (2) nach Anspruch 1 und 2, **dadurch gekennzeichnet,** daß das Handhabungsmittel (22) mit dem beweglichen Kontaktmittel verbunden ist.

5. Rückwandleiterplatte (2) nach Anspruch 1, **dadurch gekennzeichnet,** daß das Handhabungsmittel (22) einen Trennteil (26) und eine Handhabe (24) hat.

6. Rückwandleiterplatte (2) nach Anspruch 5, **dadurch gekennzeichnet,** daß das Trennteil (26) und die Handhabe (24) mechanisch trennbar sind.

7. Rückwandleiterplatte (2) nach Anspruch 5, **dadurch gekennzeichnet,** daß das Trennteil (26) des Handhabungsmittels (22) derart gestaltet ist, daß die Trennbewegung des Trennteils sich jeweils in eine Abhebbewegung der federnden Kontaktstifte ändert.

8. Rückwandleiterplatte (2) nach Anspruch 1, **dadurch gekennzeichnet,** daß die Federleisten (6) jeweils mit einem Abstandshalter (40) versehen ist, der zwischen der Rückwandleiterplatte (2) und den Federleisten (6) angeordnet ist.

## Claims

1. A backplane printed circuit board with socket connectors (6) arranged parallel to each other, side by side on the side (4) of the backplane printed circuit board that faces the module, and with at least one bus (32, 34), which consists of several bus lines (36, 38), characterised in that the contact pins (8) of the outer rows of contact pins of the socket connectors (6), provided as bus contact pins (10, 12), are shorter than the contact pins (8) of the central rows of contact pins, in that in each case the backplane printed circuit board (2) aligned with these bus contact pins (10,12) of each socket connector (6) is provided with additional contact pins (14, 16), wherein these additional contact pins (14, 16) associated with a bus (32, 34), are connected in an electrically conducting manner by means of bus lines (36, 38) and in that the bus contact pins (10, 12) of each socket connector are connected in an electrically conducting manner to the respective corresponding additional contact pins (14, 16) by way of contact means (18) movable by means of a handling means (22).

2. A backplane printed circuit board (2) according to claim 1, characterised in that as a movable contact means (18) there is provided a cylindrical contact, that is provided with a ring-shaped contact projection (20) in the interior in the end region.

3. A backplane printed circuit board (2) according to claim 2, characterised in that resilient contact pins are provided as movable contact means (18), which are connected in each case with a bus contact pin (10,12), and are held by means of their spring force to the additional contact pin (14, 16).

4. A backplane printed circuit board (2) according to claim 1 and 2, characterised in that the handling means (22) is connected to the movable contact means.

5. A backplane printed circuit board (2) according to claim 1, characterised in that the handling means (22) has a separator-part (26) and a handle (24).

6. A backplane printed circuit board (2) according to claim 5, characterised in that the separator part (26) and the handle (24) are able to be separated mechanically.

7. A backplane printed circuit board (2) according to claim 5, characterised in that the separator part (26) of the handling means (22) is shaped such that the separating motion of the separator part is converted in each case into a lifting motion of the resilient contact pins.

8. A backplane printed circuit board (2) according to claim 1, characterised in that the socket connectors (6) are each provided with a respective spacer (40), which is arranged between the backplane printed circuit board (2) and the socket connectors (6).

## Revendications

1. Plaquette à circuits imprimés de paroi arrière (2) comportant plusieurs barrettes à ressorts (6) disposées sur la face (4) tournée vers les modules, et au moins un bus (32, 34) constitué de plusieurs lignes (36, 38), caractérisée par le fait que respectivement les broches de contact (8), prévues en tant que broches de contact de bus (10, 12), des rangées extérieures de broches de contact des barrettes à ressorts (6) sont plus courtes que les broches de contact (8) des rangées médianes de broches de contact, que la plaquette à circuits imprimés de paroi arrière (2) est équipée de broches supplémentaires de contact (14, 16) qui sont respectivement alignées avec ces broches de contact de bus (10, 12) de chaque barrette à ressorts (6), lesdites broches supplémentaires de contact (14, 16) associées à un bus (32, 34) étant raccordées entre elles d'une manière électriquement conductrice au moyen des lignes (36, 38) des bus, et que les broches de contact de bus (10, 12) de chaque barrette à ressorts (6) sont raccordées d'une manière électriquement conductrice respectivement aux broches supplémentaires de contact correspondante (14, 16) par l'intermédiaire d'un moyen de contact (18) déplaçable à l'aide d'un dispositif à poignée (22).

2. Plaquette à circuits imprimés de paroi arrière (2) suivant la revendication 1, caractérisée par le fait qu'il est prévu, comme moyen de contact mobile (18), un contact cylindrique qui comporte respectivement intérieurement, dans sa zone frontale, une nervure annulaire de contact (20).

3. Plaquette à circuits imprimés de paroi arrière (2) suivant la revendication 2, caractérisée par le fait qu'il est prévu comme moyen de contact mobile (18), des broches de contact élastiques, qui sont raccordées respectivement à une broche de contact de bus (10, 12) et s'appliquent, par leur force élastique, contre la broche supplémentaire de contact (14, 16).

4. Plaquette à circuits imprimés de paroi arrière (2) suivant les revendications 1 et 2, caractérisée par le fait que le dispositif à poignée (22) est raccordé au moyen de contact mobile.

5. Plaquette à circuits imprimés de paroi arrière (2) suivant la revendication 1, caractérisée par le fait que le dispositif à poignée (22) possède une partie de séparation (26) et une poignée (24).

6. Plaquette à circuits imprimés de paroi arrière (2) suivant la revendication 5, caractérisée par le fait que la partie de séparation (26) et la poignée (24) sont séparables mécaniquement.

7. Plaquette à circuits imprimés de paroi arrière (2) suivant la revendication 5, caractérisée par le fait que la partie de séparation (28) du dispositif à poignée (22) est agencée de telle sorte que le déplacement de séparation de la partie de séparation se transforme respectivement en un déplacement d'écartement des broches de contact élastiques.

8. Plaquette à circuits imprimés de paroi arrière (2) suivant la revendication 1, caractérisée par le fait que les barrettes à ressorts (6) sont équipées chacune d'une entretoise (40), disposée entre la plaquette à circuits imprimés (2) et les barrettes à ressorts (6).

FIG 1

FIG 3

FIG 2